(19) Europäisches Patentamt
European Patent Office
Office européen des brevets

(11) **EP 3 454 373 A1**

(12) **EUROPEAN PATENT APPLICATION**

(43) Date of publication:
**13.03.2019 Bulletin 2019/11**

(51) Int Cl.:
***H01L 27/30*** (2006.01)     ***H01L 51/48*** (2006.01)
***G01T 1/24*** (2006.01)

(21) Application number: **17190406.3**

(22) Date of filing: **11.09.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Siemens Healthcare GmbH**
**91052 Erlangen (DE)**

(72) Inventors:
- **BIELE, Markus**
**91058 Erlangen (DE)**
- **GREGORI, Alberto**
**91052 Erlangen (DE)**
- **HÜRDLER, Judith Elisabeth**
**90419 Nürnberg (DE)**
- **MONTENEGRO BENAVIDES, Cindy**
**91058 Erlangen (DE)**
- **TEDDE, Sandro Francesco**
**91085 Weisendorf (DE)**

Remarks:
Amended claims in accordance with Rule 137(2) EPC.

(54) **OPTOELECTRONIC DEVICE WITH SPRAY COATED ORGANIC SEMICONDUCTOR BASED PHOTOACTIVE LAYER WITH REDUCED DEFECTIVE PIXELS AND IMPROVED MORPHOLOGY**

(57) The present invention relates to a method of producing an organic semiconductor photoactive layer for an optoelectronic device using spray-coating, and an optoelectronic device wherein a layer produced by this method is comprised.

## FIG 2

**Description**

The present invention relates to a method of producing an organic semiconductor photoactive layer for an optoelectronic device using spray-coating, and an optoelectronic device wherein a layer produced by this method is comprised.

Image sensors today are based mainly on inorganic semiconducting materials like e.g. crystalline silicon (c-Si) or amorphous silicon (a-Si). In CMOS cameras c-Si is the state of the art, while in flat panels X-Ray detectors a-Si is the technology of choice. Deposition methods for these materials are extremely costly and time consuming (e.g. wafer growth, wafer preparation, diffusion of p and n regions for CMOS and PECVD for a-Si).

In optoelectronic devices, as well as also e.g. in solar cells, etc., organic semiconductor photoactive layers are present for photo-conversion of radiation irradiated upon the device. These can be produced by a variety of methods, as e.g. disclosed in Chochos, C. L. et al., "Rational Design of High-Performance Wide-Bandgap ($\approx$ 2 eV) Polymer Semiconductors as Electron Donors in Organic Photovoltaics Exhibiting High Open Circuit Voltages ($\approx$ 1 V)", Macromolecular Rapid Communications, 2016, DOI: 10.1002/marc.201600614; Aïch, B. R et al., "Control of the active layer nanomorphology by using co-additives towards high-performance bulk heterojunction solar cells", Organic Electronics, 13(9), pp. 1736-1741, 2012; Pivrikas, A. et al., "Influence of processing additives to nano-morphology and efficiency of bulk-heterojunction solar cells: A comparative review", Solar Energy, 85(6), pp. 1226-1237, 2011; Salim, T et al., "Solvent additives and their effects on blend morphologies of bulk heterojunctions", Journal of Materials Chemistry, 21(1), pp. 242-250, 2011; WO 2017/011239 A1; US 2016/0087219 A1; WO 2015/171640 A1; and US 2017/0062725 A1.

Spray coating serves as low-cost fabrication method for coating organic thin film (few hundreds of nm) photoactive layers in organic photodetectors (OPDs) and image sensors, as reported in US20140021454 A1 - directed to multiple spray coating, as well as in publications on spray-coated OPDs (Sandro F. Tedde et al., "Fully Spray Coated Organic Photodiodes", Nano Lett., 2009, 9 (3), 980-983, DOI: 10.1021/nl803386y) and on spray coated image sensors (Daniela Baierl et al., "A hybrid CMOS-imager with a solution-processable polymer as photoactive layer", Nature Communications, 2012, 3:1175, DOI: 10.1038/ncomms2180).

In particular, a high roughness of spray coated photoactive layers can generate an excessive number of defective pixels / defective pixel clusters in image sensors, which prevents this coating technology from industrialization. In case valleys in the spray coated photoactive layer are too deep, a short between top and bottom electrode may occur, and one or more adjacent pixels can be shorted and become defective. As defective pixel clusters cannot be easily removed via software, these defects may pose a problem. Software correction of defective pixels usually can be carried out e.g. with filtering techniques (e.g. Gaussian, Median etc.), which is also applied in state of the art commercially available image sensors. The drawback is a loss in resolution and thus image quality.

Moreover, the defects can strongly affect the production yield of image sensors fabricated by a spray-coating technique.

In addition, the presence of pinholes in a top electrode due to a high roughness of a spray-coated photoactive layer may also generate defective pixels / defective pixel clusters.

However, thin optoelectronic devices based on solution-processable organic semiconductors require a high planarity and a low roughness to achieve an acceptable yield (no shorted devices/defective pixels) and high uniformity in dark and illuminated images.

Also, a non-uniform phase segregation (nano-morphology) of donor acceptor moieties in the entire bulk photoactive layer can lead to reduced quantum efficiency.

Due to the above challenges, spray coated image sensors based on organic semiconductor are not on the market yet.

Several considerations can be made to optimize the spray-coating process.

For example, an increase of the average photoactive layer thickness can lead to a higher fabrication yield with e.g. less defective pixels, however limiting the external quantum efficiency (EQE) due to an increased recombination of charge carriers. Moreover, the surface roughness increases together with the layer thickness.

Also a use of alternative solvents with higher boiling point can be considered. However, a removal of the solvent in the post-spray coating process, e.g. during annealing and/or application of a vacuum, can become an issue, and high boiling point solvents do usually not allow spray-coating of a thick layer (>500nm) in one step. Furthermore, high boiling point solvents show lower adhesion properties as droplets are pushed sideward by the pressure gas of the airbrush in a wet spray.

Another consideration would be the optimization of the spray-coating parameters, like nozzle gauge, distance, air and solution flow (droplet size variation). However, at a certain point the droplets merge and start flowing away from the substrate, particularly in wet spraying. Therefore also the roughness range is limited when optimizing the spray-coating parameters alone.

In addition, also an optimization of post deposition treatments like vapor and dry annealing under inert atmosphere and solvent saturated environment, vacuum drying, etc. could be considered. However, there is only limited applicability, and the problem of surface roughness may still prevail.

Therefore there is a need for an improved method for producing organic semiconductor photoactive layers with reduced surface roughness and a reduced number of defective pixels.

Summary of the invention

The present inventors found out that by adding an additive with a specific boiling point in the spray-coating process to the host solvent comprising the organic semiconductor photoactive material, the surface roughness of a layer produced thereby as well as the number of defective pixels in an optoelectronic device comprising a layer produced thereby can be significantly reduced.

Additives used in the state of the art for spray-coating generally focus on the increase in efficiency of the bulk-heterojunction, e.g. increased exciton splitting, transport and charge collection, etc., due to an improvement of the nano-morphology, i.e. a phase separation between donor and acceptor. However, this disclosure focuses on the macro-morphology and the effect of the additive on the photoactive layer roughness, as particularly spray-coating is affected by high roughness in general, but otherwise enables an easy fabrication with a high throughput of layers with thicknesses that cannot be produced otherwise, e.g. by spin coating, screen printing, doctor blading, etc.

In a first aspect, the present invention relates to a method of producing an organic semiconductor photoactive layer for an optoelectronic device, the method comprising spray-coating a mixture comprising an organic semiconductor photoactive material of the organic semiconductor photoactive layer on a substrate, wherein the mixture further comprises at least a host solvent and an additive, wherein the additive has a boiling point of at least 200°C and the host solvent has a boiling point below 200°C, wherein a boiling point difference between the host solvent and the guest additive is at least 70°C, preferably at least 100°C, further preferably at least 150°C, thereby producing the organic semiconductor photoactive layer.

Furthermore the present invention relates in a second aspect to an optoelectronic device comprising at least a bottom and a top electrode and an organic semiconductor photoactive layer between the bottom and top electrode, wherein the organic semiconductor photoactive layer is produced by the method of the present invention.

Further aspects and embodiments of the invention are disclosed in the dependent claims and can be taken from the following description, figures and examples, without being limited thereto.

Figures

The enclosed drawings should illustrate embodiments of the present invention and convey a further understanding thereof. In connection with the description they serve as explanation of concepts and principles of the invention. Other embodiments and many of the stated advantages can be derived in relation to the drawings. The elements of the drawings are not necessarily to scale towards each other. Identical, functionally equivalent and acting equal features and components are denoted in the figures of the drawings with the same reference numbers, unless noted otherwise.

Figure 1 shows a schematic layer stack of an OPD with a spray-coated bulk-heterojunction (BHJ) according to the state of the art.

Figure 2 shows a schematic layer stack of an OPD with a spray-coated BHJ according to the present invention.

Figure 3 shows a schematic layer stack of an OPD with a spray-coated BHJ with an additional hole blocking layer in standard architecture according to the state of the art.

Figure 4 shows a schematic layer stack of an OPD with a spray-coated BHJ with an additional hole blocking layer in standard architecture according to the present invention.

Figures 5 and 6 show a schematic layer stack of an OPD with a spray-coated BHJ with additives (micromorphology) in standard and inverted architecture according to the present invention, respectively.

In Figure 7 an image sensor with a spray-coated BHJ according to the state of the art is depicted, and in Figure 8 an image sensor with a spray-coated BHJ according to the present invention.

Figures 9 and 10 show an image sensor with a spray-coated BHJ with an additional hole blocking layer in standard architecture according to the state of the art and according to the present invention, respectively.

Figures 11 and 12 show an image sensor with a spray-coated BHJ with additives (micromorphology) in standard and inverted architecture according to the present invention, respectively.

Figures 13 and 14 show an X-ray image sensor in standard architecture with a spray-coated BHJ according to the state of the art and according to the present invention, respectively.

Figures 15 to 22 show the nanomorphology of a spray-coated BHJ in the present examples.

In Figures 23 and 24 topographical profiles of spray-coated BHJs in a comparative example and an example of the present invention are given.

Figures 25 and 26 show data of the electrical characterization of a comparative example and an example of the present invention.

Figures 27 and 28 show defective pixels (dark images) in an imager of a comparative example according to the state of the art.

Figures 29 and 30 show defective pixels (dark images) in an imager of an example of the present invention.

Detailed description of the present invention

Definitions

Unless defined otherwise, technical and scientific terms used herein have the same meaning as commonly understood by one of ordinary skill in the art to which this invention belongs.

A bulk-heterojunction (BHJ) is a donor/acceptor-mixture containing at least two organic semiconductors or consisting thereof. It can form a mixture and/or interpenetrated network of an electron acceptor and an electron donor, wherein both the electron acceptor and the donor can be organic semiconducting materials which can be e.g. either polymers and/or small molecules. The bulk-heterojunction is - according to certain embodiments - a mixture of electron and hole conductors, e.g. PCBM ([6,6]-phenyl-$C_{61}$-butyric acid methyl ester) and P3HT (poly(3-hexylthiophen-2,5-diyl)), forming the bulk-heterojunction. In a bulk-heterojunction the mixing ratio - in wt.% - can be chosen arbitrarily, and is not particularly restricted. It can be chosen according to the materials used, and can be e.g. within a range of 8:1 to 1:8, e.g. 4:1 to 1:4, e.g. 3:1 to 1:3, e.g. 2:1 to 1:2, e.g. about 1:1 (wt. : wt.). A BHJ can comprise more than two organic semiconductor materials (also called binary BHJ), e.g. be a ternary BHJ with three organic semiconductor materials, etc.

In the present description, all numerical values relating to amounts are understood to be given in wt.%, unless given otherwise or clear from context that something else is intended.

In the present invention, boiling points of a substance, e.g. the host solvent and/or the additive, refer to the boiling points at a normal pressure of 101 325 Pa, unless defined otherwise.

Before the invention is described in exemplary detail, it is to be understood that this invention is not limited to the particular component parts of the process steps of the methods described herein as such methods may vary. It is also to be understood that the terminology used herein is for purposes of describing particular embodiments only, and is not intended to be limiting. It must be noted that, as used in the specification and the appended claims, the singular forms "a," "an" and "the" include singular and/or plural referents unless the context clearly dictates otherwise. For example, the term "a" as used herein can be understood as one single entity or in the meaning of "one or more" entities. It is also to be understood that plural forms include singular and/or plural referents unless the context clearly dictates otherwise. It is moreover to be understood that, in case parameter ranges are given which are delimited by numeric values, the ranges are deemed to include these limitation values.

The present invention relates in a first aspect to a method of producing an organic semiconductor photoactive layer for an optoelectronic device, the method comprising spray-coating a mixture comprising an organic semiconductor photoactive material of the organic semiconductor photoactive layer on a substrate, wherein the mixture further comprises at least a host solvent and an additive, wherein the additive has a boiling point of at least 200°C and the host solvent has a boiling point below 200°C, wherein a boiling point difference between the host solvent and the guest additive is at least 70°C, preferably at least 100°C, further preferably at least 150°C, thereby producing the organic semiconductor photoactive layer.

In the present invention the organic semiconductor photoactive material is not particularly restricted as long as it is photoactive and an organic semiconductor material. It can comprise electron donors and/or electron acceptors, and can also comprise more than one electron donor and/or electron acceptor, e.g. ternary, quaternary blends, etc.

Possible electron donors are, for example, poly(3-hexylthiophen-2,5-diyl) (P3HT), poly[2-methoxy-5-(2-ethylhexyloxy)-1,4-phenylenevinylene] (MEH-PPV), poly[2-methoxy-5-(3',7'-dimethyloctyloxy)-1,4-phenylenevinylene] (MDMO-PPV), poly[(9,9-di-n-octylfluorenyl-2,7-diyl)-alt-(benzo[2,1,3]thiadiazol-4,8-diyl)] (F8BT), polyfluorene (PFO), poly[2,1,3-benzothiadiazole-4,7-diyl[4,4-bis(2-ethylhexyl)-4H-cyclopenta[2,1-b:3,4-b']dithiophene-2,6-diyl]] (PCPDTBT), squaraines, e.g. a hydrazone end-capped symmetric squaraine with glycolic functionalization or diazulenesquaraine, polythieno[3,4-b]thiophene) (PTT), poly(5,7-bis(4-decanyl-2-thienyl)-thieno(3,4-b)diathiazole-thiophene-2,5) (PDDTT), diketopyrrolopyrrole-based polymers like poly{2,2'-[(2,5-bis(2-hexyldecyl)-3,6-dioxo-2,3,5,6-tetrahydropyrrolo[3,4-c]pyrrole-1,4-diyl)dithiophene]-5,5'-diyl-alt-thiophen-2,5-diyl} (PDPP3T), poly[[2,5-bis(2-hexyldecyl-2,3,5,6-tetrahydro-3,6-dioxopyrrolo[3,4 c]pyrrole-1,4-diyl]-alt-[3',3"-dimethyl- 2,2':5',2"- terthiophene]-5,5"-diyl] (PMDPP3T) and poly{2,2'-[(2,5-bis(2-hexyldecyl)-3,6-dioxo-2,3,5,6-tetrahydropyrrolo[3,4-c]pyrrole-1,4-diyl)dithiophene]-5,5'-diyl-alt-terthiophen-2,5-diyl} (PDPP5T), poly[2,6-4,8-di(5-ethylhexylthienyl)benzo[1,2-b;3,4- b]dithiophene-alt-5-dibutyloctyl-3,6-bis(5-bromothiophen-2-yl)pyrrolo[3,4-c]pyrrole-1,4-dione] (PBDTT-DPP), dithienosilole-based polymers like poly[(4,4-bis(2-ethylhexyl)dithieno[3,2-b:2',3'-d]silole)-2,6-diyl-alt-(4,7-bis(2-thienyl)-2,1,3-benzothiadiazole)-5,5'-diyl] (PSBTBT), 7,7'-(4,4-bis(2-ethylhexyl)-4H-silolo[3,2-b:4,5-b']dithiophene-2,6-diyl)bis(6-fluoro-4-(5'-hexyl-[2,2'-bithiophen]-5-yl)benzo[c][1,2,5]thiadiazole) (p-DTS(FBTTh2)2), poly[2,7-(9,9-dioctyl-dibenzosilole)-alt-4,7-bis(thiophen-2-yl)benzo-2,1,3-thiadiazole] (PSiFDTBT), benzodithiophene-based polymers like poly[4,8-bis[(2-ethylhexyl)oxy]benzo[1,2-b:4,5-b']dithiophene-2,6-diyl-alt-3-fluoro-2-[(2-ethylhexyl)carbonyl]thieno[3,4-b]thiophene-4,6-diyl] (PTB7), poly[(2,6-(4,8-bis(5-(2-ethylhexyl)thiophen-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione))]) (PBDB-T), poly{2,6'-4,8-di(5-ethylhexylthienyl)benzo[1,2-b;3,4-b]dithiophene-alt-5-dibutyloctyl-3,6-bis(5-bromothiophen-2-yl)pyrrolo[3,4-c]pyrrole-1,4-dione (PBDTT-DPP), poly[4,8-bis(5-(2-ethylhexyl)thiophen-2-yl)benzo[1,2-b;4,5-b']dithiophene-2,6-diyl-alt-(4-(2-ethylhexyl)-3-fluorothieno[3,4-b]thiophene-)-2-carboxylate-2-6-diyl] (PBDTT-FTTE), poly[(4,8-bis-(2-ethylhexyloxy)-benzo(1,2-b:4,5-b')dithiophene)-2,6-diyl-alt-(4-(2-ethylhexanoyl)-thieno[3,4-b]thiophene-)-2-6-diyl)] (PBDTTT-C-F), polybenzothiadiazol(thiophene)-stat-benzodithiophene(thiophene)-8 (PBTZT-stat-BDTT-8) and other polymers and/or copolymers as well as small molecules with an absorption maximum between e.g. 320-800 nm, etc.

Possible electron acceptors are, for example, fullerene derivatives like C60 PCBM - [6,6]-phenyl C61 butyric acid methyl ester, C70 PCBM - [6,6]-phenyl C71 butyric acid methyl ester, bis-C60 PCBM - bis-[6,6]-phenyl C61 butyric acid methyl ester, oQDM - o-quinodimethane C60 monoadduct and, Bis-oQDM - o-quinodimethane C60 bisadduct, ICMA - indene C60 monoadduct, ICBA - indene C60 bisadduct, fullerol - C60(OH)44 and other acceptors, e.g. polymeric and small molecules like e.g. dithienoindacene-based like 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene) (ITIC), IT-M, IT-DM and IDTBR, perylenediimide-based like TPB, SdiPDI-Se, NIDCS-HO, diketopyrrolopyrrole-based like DPP6, DTDfBT(DPP)2, SF(DPPB)4, etc.

According to certain embodiments the organic semiconductor photoactive material is a bulk heterojunction, as defined above.

According to certain embodiments the additive is mixed with the host solvent in a concentration of 0.1 vol.% or more and 30 vol.% or less, preferably 1 vol.% or more and 10 vol.% or less, further preferably 1 vol.% or more and 8 vol.% or less, even further preferably 1 vol.% or more and 4 vol.% or less, e.g. between 2 and 4 vol.%, with respect to the mixture of host solvent and additive.

In the present method, the additive - which also can be called guest additive - is not particularly restricted as long as it has a boiling point (b.p.) of at least 200°C, e.g. of at least 220°C, preferably of at least 250°C, e.g. of at least 300°C. According to certain embodiments it is liquid at room temperature of about 20 to 25°C and normal pressure of 101 325 Pa. Also more than one additive can be used in the mixture used in the present invention.

In the present method the additives preferably are high boiling temperature solvents, i.e. also can solve the organic semiconductor photoactive material, with a boiling point that is significantly higher than the boiling point of the host solvent.

According to certain embodiments the additive is at least one of the group of 4-bromoanisole (b.p. 223°C), 1,8-octanedithiol (b.p. 269°C), 1,8-diiodooctane (DIO) (b.p. 364°C (b.p. 167-169°C/6 mmHg), 2-chloronaphthalene (CN) (b.p. 259°C), 1,8-dibromooctane (b.p. 270°C), nitrobenzene (b.p. 211°C), 1,2,3,4-tetrahydronaphthalene (tetralin)(b.p. 206-208°C), 1-methylnaphthalene (1-MN) (b.p. 245°C), 2-methylnaphthalene (2-MN) (b.p. 242°C), acetophenone (b.p. 202°C), and mixtures thereof, e.g. DIO. Also isomeric mixtures of the additives are possible.

Also the host solvent is not particularly restricted, as long as the host solvent can dissolve the organic semiconductor photoactive material at least to some degree and preferably essentially in total, e.g. totally, as long as it has a boiling point below 200°C, e.g. of 180°C or less, e.g. of 150°C or less, and as long as the boiling point difference between the host solvent and the additive is at least 70°C. If more than one host solvent and/or more than one additive is present, the boiling point difference between the host solvent with the highest boiling point and the additive with the lowest boiling point should be at least 70°C.

According to certain embodiments the host solvent is at least one of the group of chlorobenzene (CB) (b.p. 131°C), chloroform (CF) (b.p. 61°C), toluene (b.p. 110°C), o-xylene (b.p. 144°C), m-xylene (b.p. 139°C), p-xylene (b.p. 138°C), 1,2-dichlorobenzene (ODCB) (b.p. 178-180°C), 2-methylanisole (b.p. 170-172°C), 3-methylanisole (b.p.

175-180°C), 4-methylanisole (b.p. 174-177°C), and mixtures thereof, e.g. CB and/or ODCB. Again, also isomeric mixtures of the host solvents are possible.

According to certain embodiments the organic semiconductor photoactive layer is further annealed after spray-coating thereof. It can be annealed at any time thereafter and alone or with other layers of an optoelectronic device. The annealing is not particularly restricted and can depend on the organic semiconductor photoactive material used. According to certain embodiments, annealing is carried out at a temperature between 25°C and 220°C, preferably between 40°C and 160°C nm, further preferably between 50°C and 120°C, even further preferably between 70°C and 100°C, e.g. at normal pressure. Also the annealing time is not particularly restricted and can be between 0.5 and 120 minutes, e.g. between 1 and 60 minutes, e.g. between 2 and 45 minutes, e.g. between 3 and 30 minutes, e.g. between 4 and 15 minutes, e.g. between 5 and 10 minutes.

Further, the substrate is not particularly restricted, and can depend on e.g. a device to be produced that comprises the organic semiconductor photoactive layer. For example, in case an optoelectronic device like an organic photodetector, an organic photodiode or an even more complex device like an image sensor, e.g. an X-ray image sensor is produced, the organic semiconductor photoactive layer can be spray-coated on an electrode or an interlayer, e.g. an electron or hole blocking layer, etc., which all are not particularly restricted.

In the present method the spray-coating itself is not particularly restricted and can be done suitably. Several parameters can influence the quality of spray-coating, which can be suitably set and optimized by a skilled person, depending e.g. on the organic semiconductor photoactive material applied, the host solvent and the solubility of the photoactive material therein, the additive, the substrate, the surrounding, etc.

According to certain embodiments, the flow rate during spray coating is between 20 and 500 $\mu$L/s, e.g. between 50 and 200 $\mu$L/s, e.g. about 100 $\mu$L/s. If the flow rate is too low, the roughness can increase and the layer thickness can decrease. If the flow rate is too high, too much solution may be pushed away from a carrier gas used in spray-coating, so that a homogeneous layer is difficult to be formed.

According to certain embodiments, the distance between the spray-nozzle and the substrate is between 2 and 25 cm, e.g. between 5 and 15 cm, e.g. about 10 cm. If the distance is too big, the roughness can increase as a layer thickness may decrease because the overspray increases and the droplets may hit the surface almost in a dry state. If it is too low, the solution can be pushed away from the carrying gas, and a homogeneous layer is difficult to form.

The temperature of the substrate during spray-coating is not particularly restricted and can be e.g. about room temperature of between 20 and 25°C. With increasing temperature the roughness may increase, which can be e.g. compensated by a shorter spraying distance, a higher spray rate and/or a faster scan rate across the substrate.

Scanning can be done by moving either the spraying nozzle across the substrate or by moving the substrate in front of the spraying nozzle, resulting in a relative movement between both, which is termed scan rate in one direction is between 0.5 and 5 cm/s, e.g. between 1 and 3 cm/s, e.g. about 2 cm/s. Scanning in other directions is not limited and can be .e.g. done stepwise with varying distances, depending on the spraying spot on the substrate. A certain overlap in area, e.g. about 30%, may be necessary between several spray-coated rows for forming a homogeneous layer.

The diameter of the nozzle is not particularly restricted and may be between e.g. between 50 and 5000 $\mu$m, e.g. between 100 and 1000 $\mu$m, e.g. between 200 and 500 $\mu$m, e.g. about 300 $\mu$m.

Also the viscosity of the solution sprayed is not particularly restricted as long as a spraying thereof is possible, and can depend on the organic semiconductor photoactive material, the host solvent, the additive, and further components, if added, as well as the spray gas, which is not particularly restricted. It may be e.g. between 0.5 and 5 mPas, e.g. between 1 and 3 mPas, e.g. about 2 mPas, as measured with a rheometer, in particular the Advanced Rheometric Expansion System (ARES) rheometer, with shear and vertical (axial) testing. Further components that may be added may be e.g. stabilizers and/or detergents and/or surfactants, like e.g. Triton X-100, etc.

Also the surrounding environment may have a minor influence on the spray-coating process, e.g. air humidity, which can e.g. be set at 50%.

In a second aspect the present invention relates to an optoelectronic device comprising at least a bottom and a top electrode and an organic semiconductor photoactive layer between the bottom and top electrode, wherein the organic semiconductor photoactive layer is produced by the present method.

In the optoelectronic device the bottom and top electrode are not particularly restricted and can be suitably set as anode and/or cathode.

For lower leakage currents, a higher dynamic range and a better image resolution, interlayers can be provided between the respective electrodes and the organic semiconductor photoactive layer, e.g. electron-blocking (hole transport) and/or hole-blocking (electron transport) interlayers (IL), which are not particularly restricted and can be suitably set by the skilled person.

Also, for better mechanical stability, a carrier layer can be provided, and/or for protection of the optoelectronic device, an encapsulation can be provided, both of which also are not particularly restricted.

Furthermore, electric connections and functional elements like thin film transistors can be provided in the optoelectronic device, as well as other components usually used in such devices. For example, using an active transistor matrix and structured electrodes, pixelated sensors, e.g. image sensors or X-ray image sensors, can be provided.

In addition, further layers can be present which can be present in optoelectronic devices of the state of the art.

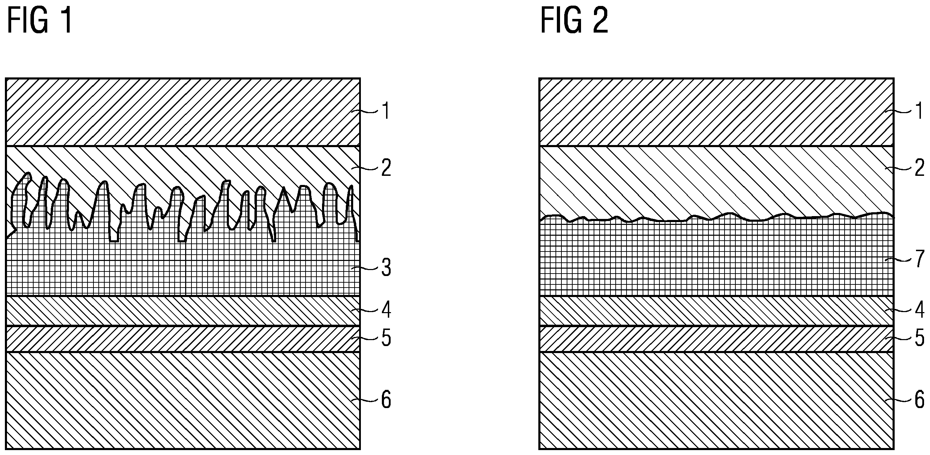

An exemplary schematic layer stack of an optoelectronic device, e.g. an organic photodetector, with a BHJ as organic semiconductor photoactive layer is shown in Figures 1 and 2, wherein Fig. 1 represents the state of the art, and Fig. 2 represents the present method, wherein the organic semiconductor photoactive layer, also simply termed photoactive layer hereinafter, was spray-coated with a mixture wherein e.g. DIO was used as additive.

In the schemes in Figures 1 and 2, an encapsulation 1 is applied on top of a top electrode 2, which is fabricated on top of a photoactive layer with a BHJ of the state of the art 3 (Fig. 1) or of the present invention 7 (Fig. 2). Below this photoactive layer 3, 7 is provided an optional electron blocking IL 4, a bottom electrode 5 and a carrier layer 6. Figures 1 and 2 particularly show the micromorphology of the photoactive layer schematically for comparison between the state of the art and the present invention.

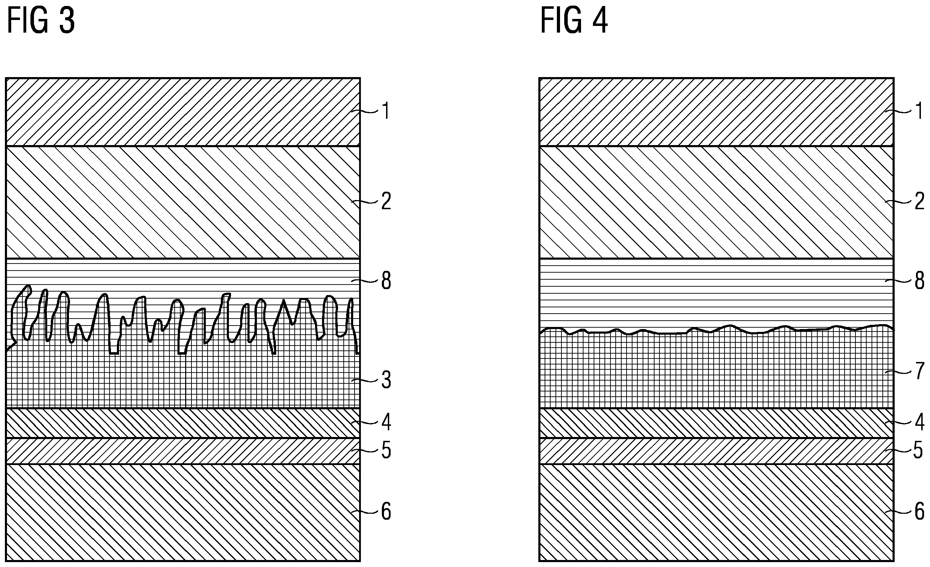

Figures 3 and 4 show a further exemplary schematic layer stack of an optoelectronic device with a BHJ as organic semiconductor photoactive layer, wherein an additional hole blocking IL 8 has been added in standard architecture between the top electrode 2 and the photoactive layer 3, 7.

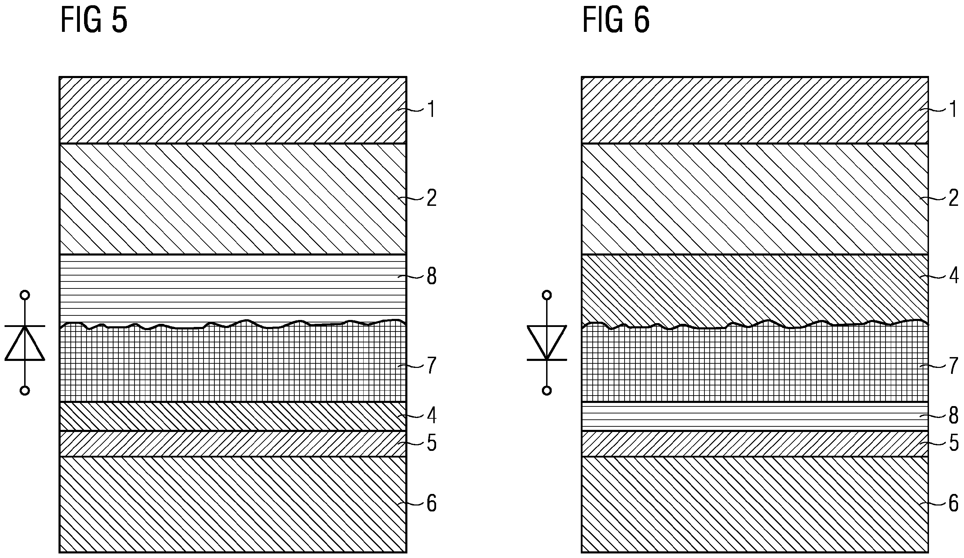

Figures 5 and 6 show that with the present concept the layer stack of the optoelectronic device can be provided in standard architecture (Fig. 5) as well as in inverted architecture (Fig. 6).

According to certain embodiments the organic semiconductor photoactive layer in the optoelectronic device has a thickness between 400 and 2000 nm, preferably between 400 and 1600 nm, further preferably between 600 and 1200 nm, even further preferably between 700 and 1000 nm, e.g. between 750 and 950 nm. Particularly such thicknesses are difficult to produce with other methods.

According to certain embodiments, a ratio of the root mean square of the roughness Rq, $R_q = \sqrt{\frac{1}{n}\sum_{i=1}^{n} y_i^2}$ , with $y_i$ being the vertical distance from the mean line to the ith data point and n being a natural positive number, particularly measured over a scan length of 1.2 mm with a line scanner, e.g. a tactile profilometer, to the, e.g. mean, thickness of the organic semiconductor photoactive layer is smaller than 0.15, preferably smaller than 0.1. In this regard, the mean thickness is the average thickness of the layer produced, so that the surface roughness is determined as a derivation thereof, which can be particularly relevant for thicker layers.

According to certain embodiments, the root mean square of the roughness of the organic semiconductor photoactive layer is less than 100 nm, preferably less than 50 nm, particularly over a scan length of 1.2 mm with a line scanner.

According to certain embodiments, the organic semiconductor photoactive layer has less than 100 defective pixels in 1 million pixels, preferably less than 50 defective pixels in 1 million pixels, further preferably less than 20 defective pixels in 1 million pixels. The pixel size may of course vary and be e.g. derived from a pixel pitch of 98 $\mu$m of a square pixel, thus defining one pixel.

The present optoelectronic device can be in a variety of forms and can be e.g. an organic photodetector, preferably an image sensor, e.g. a pixelated image sensor. For such a pixelated image sensor, pixelated, i.e. structured, electrodes, e.g. bottom electrodes, can be applied.

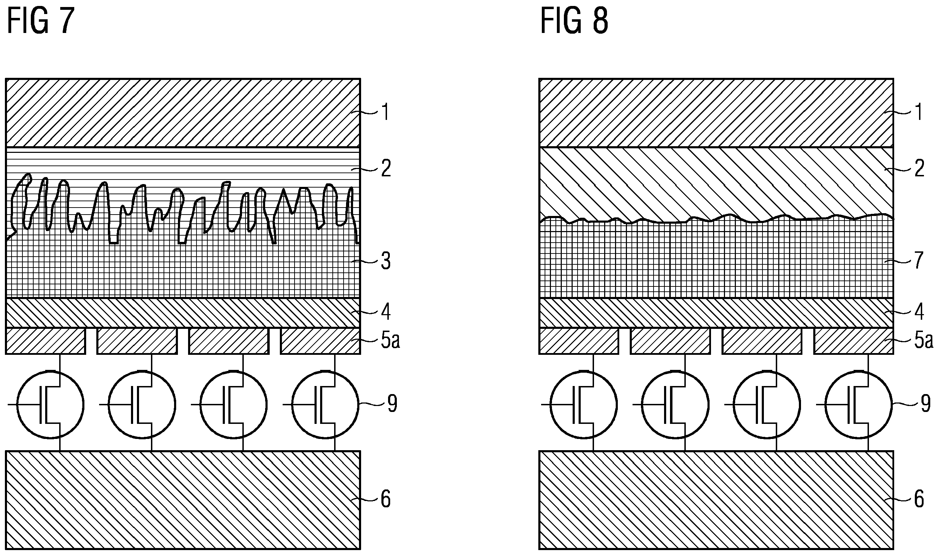

Such an image sensor with pixelated bottom electrode is show in Figures 7 and 8, wherein the respective layers are like in Figures 1 and 2. Figure 7 again represents the state of the art, and Figure 8 the present invention. In the image sensor of Figures 7 and 8, structures bottom electrodes 5a replace the bottom electrode 5 of Figures 1 and 2. Below these, thin film transistors 9 for an active matrix driving scheme are provided for contacting each of these structured bottom electrodes 5a.

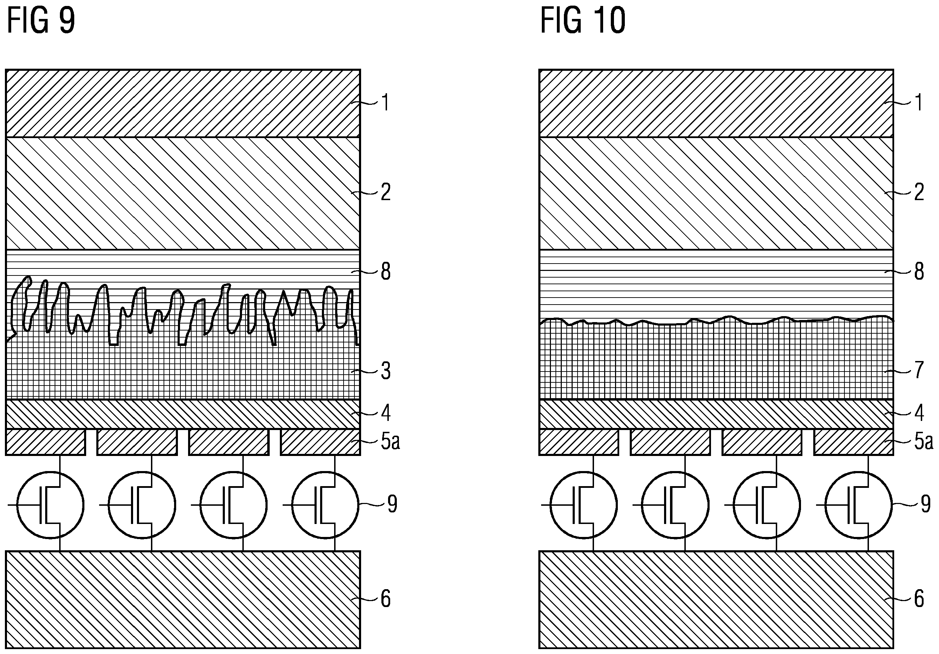

Figures 9 and 10 show that also hole blocking layers 8 can be provided in such image sensors, similar to Figures 3 and 4, and Figures 11 and 12 show that both standard and inverted architectures can be realized in the image sensor, similar to Figures 5 and 6. Again, also the presence of further layers is not excluded.

Thus, image sensors can be realized with spray-coated organic semiconductor photoactive layers, particularly with bulk heterojunctions, with reduced defective pixels and improved morphology by addition of the additive in the solution used for spray coating, i.e. by using improved spray-coating formulations.

According to certain embodiments, the optoelectronic device is an organic photodiode, preferably with a rectification ratio in the dark at +2V/-2V (current at +2V divided by current at -2V) of at least $> 1\times10^5$ , preferably $> 1\times10^6$, even further preferably $> 1\times10^7$. Again, such an organic photodiode can be used in an image sensor, e.g. a pixelated image sensor, e.g. with an active matrix driving scheme.

According to certain embodiments, the optoelectronic device further comprises a scintillator layer and is an X-ray image sensor, e.g. a pixelated X-ray image sensor. It can be e.g. a flat panel X-Ray detector.

In such an X-ray image sensor the scintillator layer is not particularly restricted as long as it comprises one or more suitable scintillators, which can be adapted e.g. to the organic semiconductor photoactive material with regard to the emission wavelength. Particularly, the scintillator is chosen in a way that the emission spectrum of the scintillator matches with the absorption spectra of the photoactive layer, e.g. BHJ.

Possible scintillators in an X-Ray image sensors include e.g. CsI:Tl (cesium iodide, doped with thallium), Gd2O2S:Pr,Ce (gadolinium oxysulfide, doped with praseodymium and cerium), Gd2O2S:Tb (gadolinium oxysulfide, doped with terbium with an emission maximum at approximately 545 nm), Gd2O2S:Pr,Ce,F (gadolinium oxysulfide, doped with praseodymium or cerium or fluorine), YAG:Ce (yttrium aluminum garnet doped with cerium), CsI:Tl (cesium iodide, doped with thallium), CdI2:Eu (europium-doped cadmium iodide), Lu2O3:Tb (lutetium oxide doped with terbium), Lu2SiO5:Ce bzw. LSO (cerium doped lutetium oxyorthosilicate), Lu1.8Y.2SiO5:Ce (cerium doped lutetium oxyorthosilicate), CdWO4 (cadmium tungstate), CsI:Na (Cesium iodide, doped with sodium), NaI:Tl (thallium doped sodium iodide), Bi4Ge3O12 bzw. BGO (bismuth germanate), Gd2SiO5 bzw. GSO (gadolinium oxyorthsilicate doped with cerium), CsBr:Eu (cesium bromide, doped with europium), Lu2O3:Eu (lutetium oxide doped with europium), Lu2O3:Tb (lutetium oxide doped with terbium), Gd2O3:Eu (gadolinium oxysulfide, doped with europium), YGdO:(Eu,Pr) (europium and/or praseodymium doped Yttrium gadolinium oxide), GdGaO:Cr,Ce (chromium and/or cesium doped gadolinium gallium oxide), CuI (copper iodide), GAGG:(Ce,Pr) (cerium and/or praseodymium doped Gadolinium Aluminium Gallium Garnet), and other inorganic or organic scintillators which might match with the absorption spectrum of the organic semiconductor photoactive material, e.g. a BHJ.

The other layers in such an X-ray image sensor can be the same as in the above image sensor, and can be suitably applied, so that also e.g. a pixelated image sensor can be provided, e.g. with an active matrix driving scheme.

The scintillator layer can be produced by suitable methods known from the state of the art, which are not particularly restricted, and can be provided at a suitable location in the X-ray image sensor.

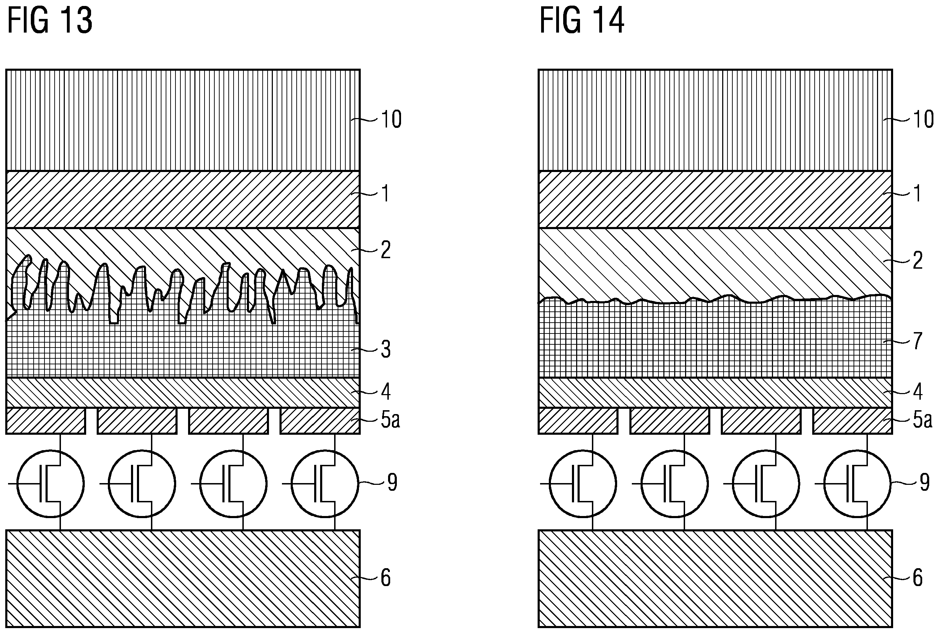

A coupling of a scintillator layer with an image sensor to produce an X-ray image sensor, e.g. an X-ray detector, e.g. with a large are scintillator layer, is shown in Figures 13 and 14, wherein Figure 13 again represents the state of the art and Figure 14 the present invention. The X-ray image sensors in Figures 13 and 14 thereby are similar to the image sensors in Figures 7 and 8, and the layers are mostly identical. The only difference is that a scintillator layer 10 is provided on top of the encapsulation 1. While in these figures the scintillator layer 10 is shown on top, it can also be at another suitable location if irradiation that leads to the scintillation can reach it.

For image sensors, one of the top and bottom electrodes usually should be suitably transparent for a light to be detected, e.g. in a visible light image sensor or in an X-ray image sensor, where the BHJ detects the visible light. Depending on the setup, e.g. a top or bottom detecting device, the corresponding electrode should be suitably transparent, as well as e.g. an encapsulation or a substrate, optional interlayers, etc. A suitable transparency may be >70%, preferably >80% and more preferably >90%, e.g. 95% or more, e.g. 99% or more, e.g. essentially 100%.

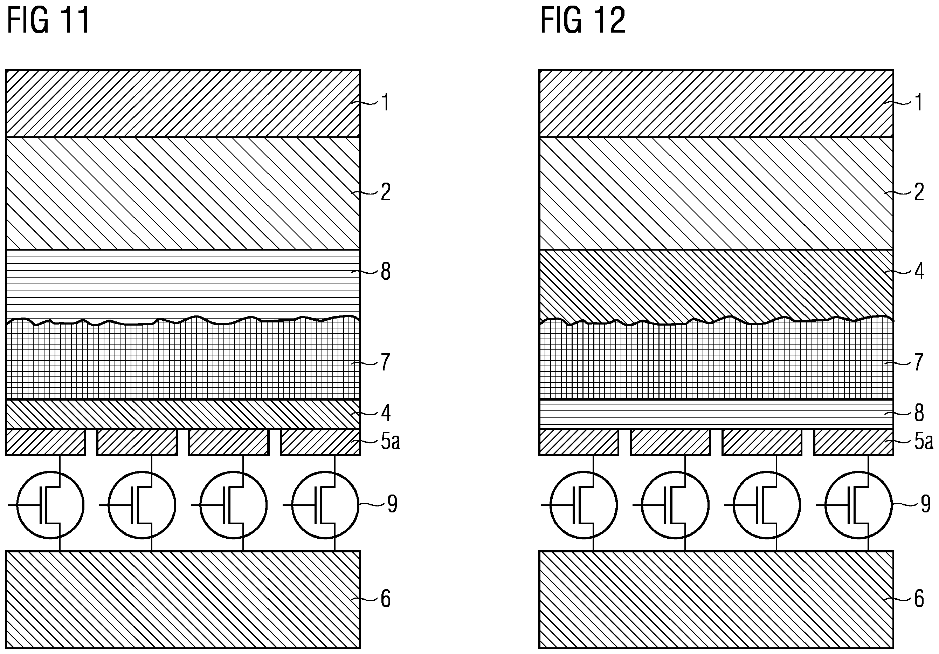

Again in an X-ray image sensor, also an additional hole blocking layer as in Figures 9 and 10, with standard or inverted structure as in Figures 11 and 12, can be present, as well as other layers.

The above embodiments can be combined arbitrarily, if appropriate. Further possible embodiments and implementations of the invention comprise also combinations of features not explicitly mentioned in the foregoing or in the following with regard to the Examples of the invention. Particularly, a person skilled in the art will also add individual aspects as improvements or additions to the respective basic form of the invention.

Examples

The present invention will now be described in detail with reference to several examples thereof. However, these examples are illustrative and do not limit the scope of the invention.

Comparative Example 1 and Example 1:

An exemplary mixture for spray coating in Comparative Example 1 and Example 1 was prepared as follows:

PDPP3T (donor) (3mg/mL) and [70]PCBM (acceptor)(6mg/mL) were used for producing a BHJ with a mixing ratio of 1:2 (donor:acceptor).

For comparative example 1, the BHJ was dissolved in chlorobenzene (CB) in solvent, and for Example 1 in a mixture of chlorobenzene (CB) with 3 vol.% DIO, based on the mixture of chlorobenzene and DIO, in equal amounts. The resulting solution for spray-coating in both cases had a viscosity of about 2 mPas, as measured with an Advanced Rheometric Expansion System (ARES) rheometer with shear and vertical (axial) testing.

Spray-coating was carried out at room temperature and an air humidity of 50% at a flow rate of about $100\mu L/s$ with a distance between the spray-nozzle - having a nozzle diameter of 300 $\mu$m) - and the substrate of about $5x5cm^2$. The solution was spray coated on top of a backplane (sodalime glass with a-Si TFT array of 256x256 elements and an indium tin oxide (ITO) bottom electrode per each pixel; substrate size 2 inch X 2 inch; pixel pitch $98\mu m$).

During spray-coating the substrate was moved in respect to the spraying nozzle with a speed in X direction of 2cm/sec. In Y direction discrete steps of about 1cm were carried out, with an overlap of about 30% between Y1 and Y1+1 (next row) for producing a homogeneous layer.

After spray-coating the layer was annealed at 70 to 100°C for about 5-10 minutes.

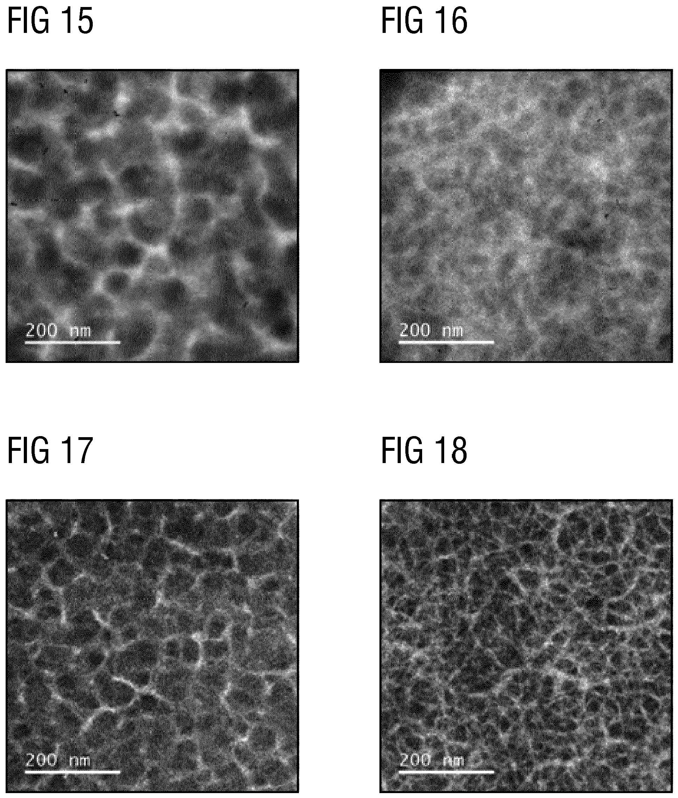

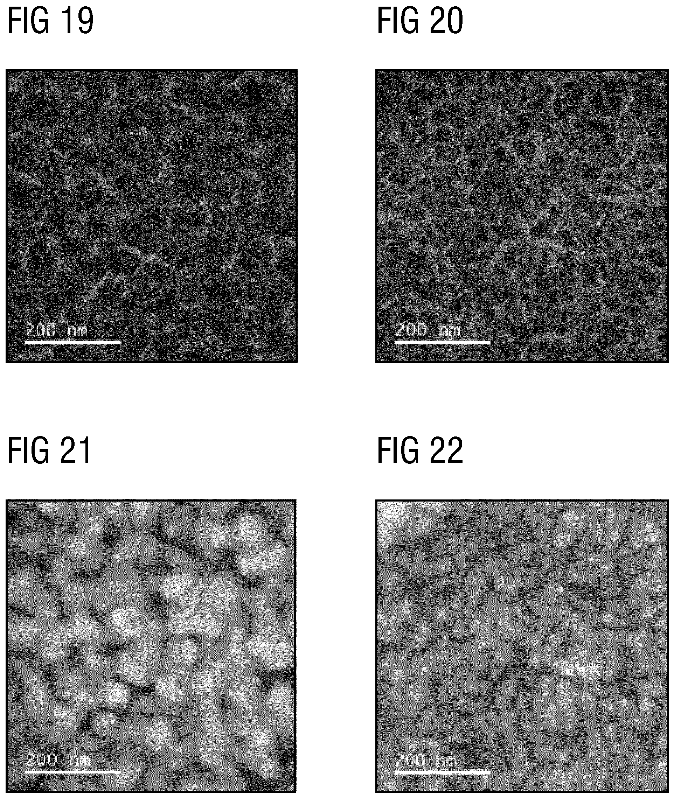

Bright field TEM images were recorded for Comparative Example 1 and Example 1, which are shown in Figures 15 and 16. Further, pre-carbon images at 267 +/- 15 eV were acquired directly before the C edge, thus suppressing the C signal, which are shown in Figures 17 (Comparative Example 1) and 18 (Example 1). In addition, elemental maps of sulfur using the S L2,3 edge were also recorded, which are shown in Figures 19 (Comparative Example 1) and 20 (Example 1). Furthermore, elemental maps of carbon using the C K edge were recorded, which are shown in Figures 21 (Comparative Example 1) and 22 (Example 1). From the figures already the more homogeneous layer in Example 1 can be seen.

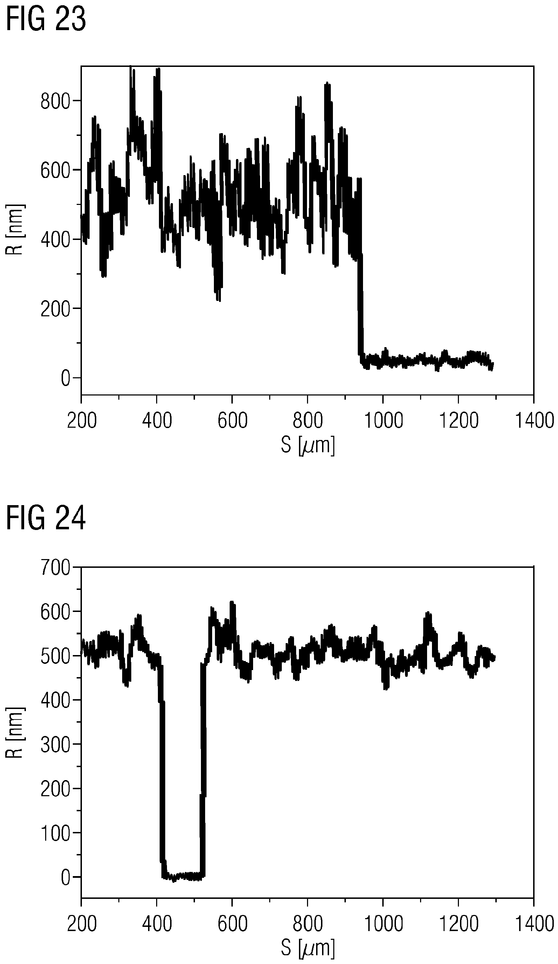

For testing the roughness of the produced layers, a topographical profile was recorded with a tactile profilometer, the KLA Tencor P-15 Profilometer. The results thereof are shown in Figures 23 (Comparative Example 1) and 24 (Example 1), wherein scratches were made in the layer for measuring the thickness of the layer produced. Shown is the roughness R in nm versus the scan length in $\mu$m. From the Figures, it can be seen that the roughness of the layer is significantly reduced in Example 1.

Furthermore, an electro-optical characterization of the produced layers was carried out after producing organic photodetectors, wherein a top electrode and bottom electrode were attached. The details are as follows:

On top of indium tin oxide (ITO), a poly(9,9-dioctylfluorene-alt-N-(4-butylphenyl)-diphenylamine) TFB interlayer was spin coated and baked at 150°C in a vacuum oven for one hour. Thereafter, a solution of PDPP3T:PC70BM with a ratio of 1:2 was stirred overnight, filtered (0.1 $\mu$m PTFE) and spray deposited at room temperature under clean room conditions in air. Finally, 100 nm of Aluminum (Al) were evaporated at an average deposition rate of 0.2 nm/s at a vacuum of ~1E-6mbar.

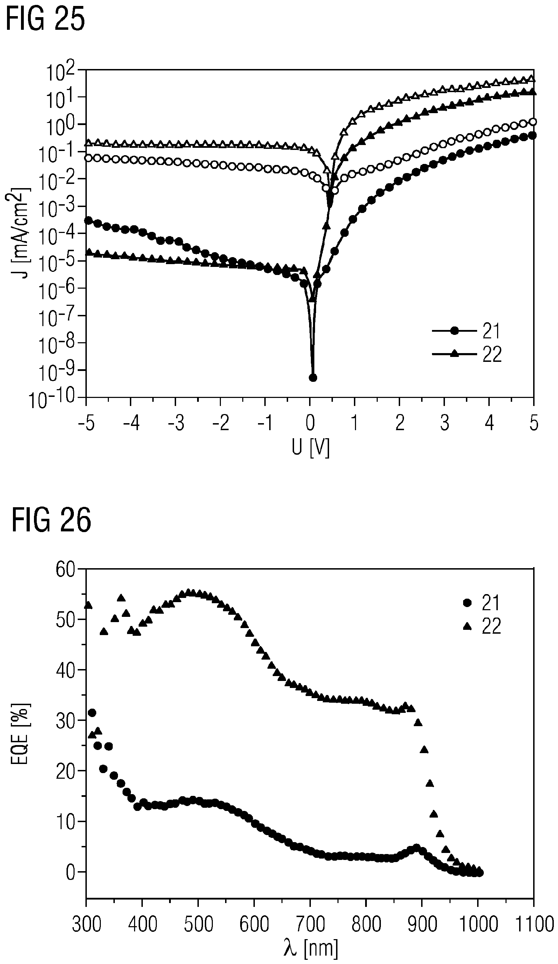

Figure 25 and Figure 26 show the result of the electro-optical characterization of the produced OPDs, with photoactive area of 1cm$^2$, with (Example 1, reference number 22) and without DIO (Comparative Example 1, reference number 21). Figure 25 therein shows the current density - voltage (J-U) characteristics under dark (solid symbols) and under green light (open symbols) at 532 nm at 680 $\mu$W/cm$^2$ for OPDs with a thickness of the BHJ of about 500 nm. Figure 26 shows the external quantum efficiency of the OPDs at -5V versus the wavelength (nm). From the Figures the improved results with the layer produced in Example 1 can be confirmed.

As known in literature, the better performance is due to improved nanomorphology (better phase separation between donor and acceptor), as also shown in Figures 25 to 22.

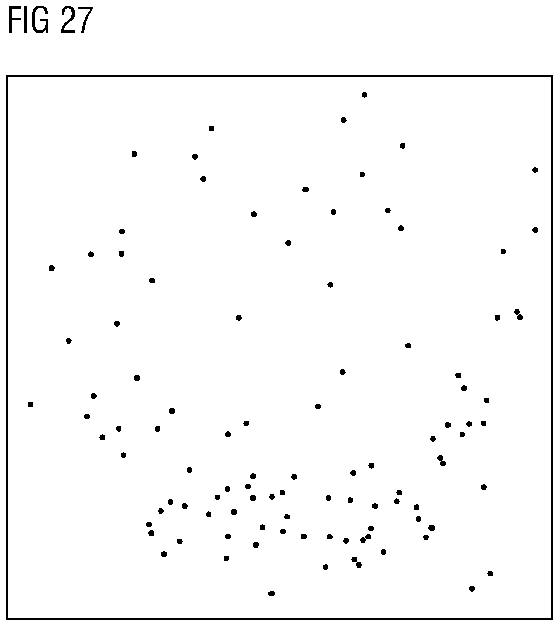

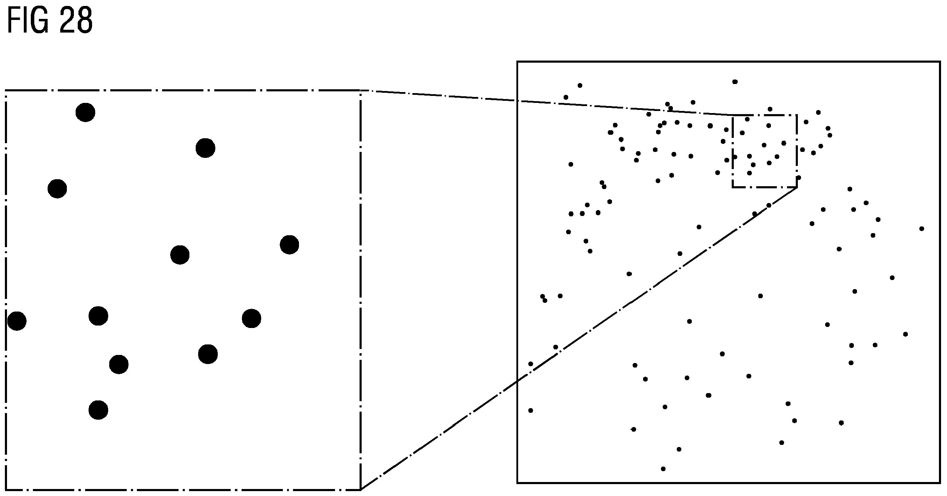

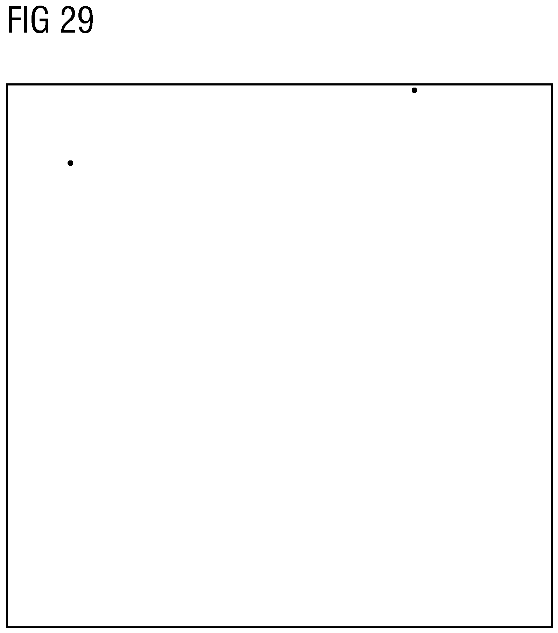

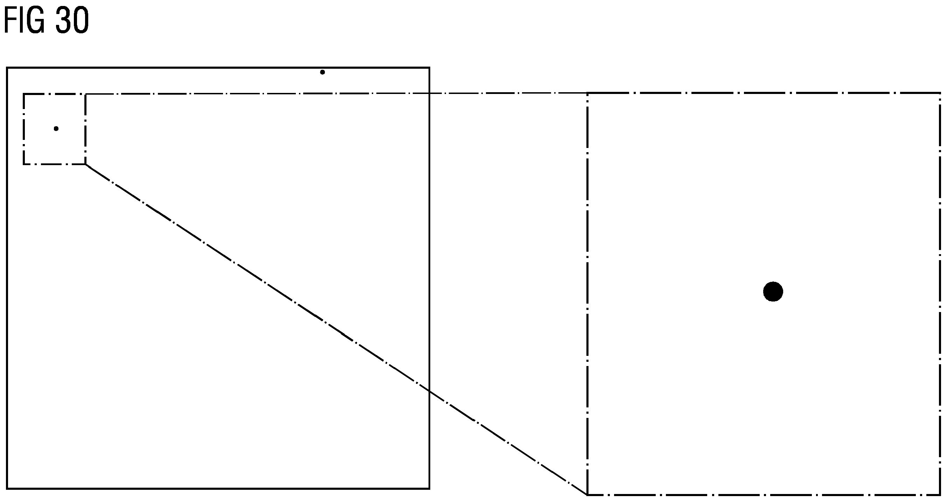

Furthermore, dark images (images have been inverted thus defective pixels result as black pixels) were recorded with the OPDs made with the layers of Comparative Example 1 and Example 1, and the results thereof are shown in Figures 27 and 28 for Comparative Example 1 and in Figures 29 and 30 for Example 1. The ROIC (readout integrated circuit) used for readout of the image sensor was the Indigo ISC9717 from Flir. The settings were: bias 5V reverse bias, hole detection (+5V on top electrode) mode, 2pF feedback capacitance, room temperature, raw images. From these images, the numbers of defective pixels were counted.

The imagers realized with the improved formulations (host solvent + additive + donor + acceptor) in Example 1 show a significant reduction of defective pixels, as shown in Figures 29 and 30.

As can be seen from a comparison of Figures 27 to 30 6, the number of defective pixels had been reduced for 2 orders of magnitude. The imager produced with DIO (Example 1) had 1 defective pixel of totally 65536 pixels, meaning 15 defective pixels per million pixels, whereas the imager without DIO had >100 defective pixel of totally 65536 pixels, meaning >1525 defective pixels per million pixels.

Example 2

Further organic semiconductor photoactive layers have been produced with the same BHJ as in Example 1 and Comparative Example 1 with different solvents, as given in Table 1 below, representing further comparative examples and examples. In Table 1 also the resulting thicknesses and roughness are given.

Table 1

| Host solvent | Additive | Annealed | Thickness [nm] | Roughness rms | Ratio rms/thickness |
|---|---|---|---|---|---|
| 100%CB | | No | 450 | 62,9 | 0,14 |
| 100%CB | | Yes | 394 | 65,34 | 0,17 |
| 99.9%CB | 0.1%DIO | Yes | 844 | 104 | 0,12 |

(continued)

| Host solvent | Additive | Annealed | Thickness [nm] | Roughness rms | Ratio rms/thickness |
|---|---|---|---|---|---|
| 99%CB | 1%DIO | Yes | 807 | 67 | 0,08 |
| 98%CB | 2%DIO | Yes | 853 | 61,28 | 0,07 |
| 97%CB | 3%DIO | Yes | 863 | 34 | 0,04 |
| 100%CB | | No | 726 | 134 | 0,18 |
| 100%CB | | Yes | 640 | 130 | 0,20 |
| 98%ODCB | 2%CN | No | 611 | 49 | 0,08 |
| 98%ODCB | 2%CN | Yes | 556 | 39 | 0,07 |
| 100%Toluene | | No | 724 | 131 | 0,18 |
| 100%Toluene | | Yes | 680 | 122 | 0,18 |
| 98%Toluene | 2%ODCB | No | 867 | 94 | 0,11 |
| 98%Toluene | 2%ODCB | Yes | 800 | 104 | 0,13 |
| 90%Toluene | 10%ODCB | No | 716 | 88,5 | 0,12 |
| 90%Toluene | 10%ODCB | Yes | 1100 | 159 | 0,14 |

From the table it is clear that the method of the present invention produces an improved roughness compared to the state of the art.

Using engineered formulations of the spraying solution for the fabrication of organic semiconductor photoactive layers, e.g. in image sensors, e.g. pixelated detectors based on organic semiconductors and particularly the bulk-heterojunction concept, a reduction of defective pixels and surface roughness can be achieved, which allows the spray-coating process to be used on industrial level for the fabrication of e.g. image sensors and flat panel X-Ray detectors with a limited number of defective pixels and a huge cost and time saving potential.

**Claims**

1. A method of producing an organic semiconductor photoactive layer for an optoelectronic device, the method comprising spray-coating a mixture comprising an organic semiconductor photoactive material of the organic semiconductor photoactive layer on a substrate, wherein the mixture further comprises at least a host solvent and an additive, wherein the additive has a boiling point of at least 200°C and the host solvent has a boiling point below 200°C, wherein a boiling point difference between the host solvent and the guest additive is at least 70°C, preferably at least 100°C, further preferably at least 150°C, thereby producing the organic semiconductor photoactive layer.

2. The method of claim 1, wherein the organic semiconductor photoactive material is a bulk heterojunction.

3. The method of claim 1 or 2, wherein the additive is mixed with the host solvent in a concentration of 0.1 vol.% or more and 30 vol.% or less, preferably 1 vol.% or more and 10 vol.% or less, further preferably 1 vol.% or more and 4 vol.% or less, with respect to the mixture of host solvent and additive.

4. The method of any one of claims 1 to 3, wherein the additive is at least one of the group of 4-bromoanisole, 1,8-octanedithiol, 1,8-diiodooctane, 2-chloronaphthalene, 1,8-dibromooctane, nitrobenzene, 1,2,3,4-tetrahydronaphthalene, 1-methylnaphthalene, 2-methylnaphthalene, acetophenone, and mixtures thereof.

5. The method of any one of claims 1 to 4, wherein the host solvent is at least one of the group of chlorobenzene, chloroform, toluene, o-xylene, m-xylene, p-xylene, 1,2-dichlorobenzene, 2-methylanisole, 3-methylanisole, 4-methylanisole, and mixtures thereof.

6. The method of any one of claims 1 to 5, wherein the organic semiconductor photoactive layer is further annealed after spray-coating thereof.

7. Optoelectronic device comprising at least a bottom and a top electrode and an organic semiconductor photoactive layer between the bottom and top electrode, wherein the organic semiconductor photoactive layer is produced by the method of any one of claims 1 to 6.

8. The optoelectronic device of claim 7, wherein the organic semiconductor photoactive layer has a thickness between 400 and 2000 nm, preferably between 400 and 1600 nm, further preferably between 600 and 1200 nm, even further preferably between 700 and 1000 nm, e.g. between 750 and 950 nm.

9. The optoelectronic device of claim 7 or 8, wherein a ratio of root mean square of the roughness to the, e.g. mean, thickness of the organic semiconductor photoactive layer is smaller than 0.15, preferably smaller than 0.1.

10. The optoelectronic device of any one of claims 7 to 9, wherein the root mean square of the roughness of the organic semiconductor photoactive layer is less than 100 nm, preferably less than 50 nm.

11. The optoelectronic device of any one of claims 7 to 10, wherein the organic semiconductor photoactive layer has less than 100 defective pixels in 1 million pixels, preferably less than 50 defective pixels in 1 million pixels, further preferably less than 20 defective pixels in 1 million pixels.

12. The optoelectronic device of any one of claims 7 to 11, wherein the optoelectronic device is an organic photodetector, preferably an image sensor, e.g. a pixelated image sensor.

13. The optoelectronic device of any one of claims 7 to 11, wherein the optoelectronic device is an organic photodiode, preferably with a rectification ratio in the dark at +2V/-2V of at least $> 1 \times 10^5$, preferably $> 1 \times 10^6$, even further preferably $> 1 \times 10^7$.

14. The optoelectronic device any one of claims 7 to 11, wherein the optoelectronic device further comprises a scintillator layer and is an X-ray image sensor, e.g. a pixelated X-ray image sensor.

15. The optoelectronic device of claim 14, wherein the X-ray image sensor is a flat panel X-Ray detector.

**Amended claims in accordance with Rule 137(2) EPC.**

1. A method of producing an organic semiconductor photoactive layer for an optoelectronic device, the method comprising spray-coating a mixture comprising an organic semiconductor photoactive material of the organic semiconductor photoactive layer on a substrate, wherein the mixture further comprises at least a host solvent and an additive, wherein the additive has a boiling point of at least 200°C and the host solvent has a boiling point below 200°C, wherein a boiling point difference between the host solvent and the guest additive is at least 70°C, preferably at least 100°C, further preferably at least 150°C, thereby producing the organic semiconductor photoactive layer, wherein the organic semiconductor photoactive layer has a thickness between 400 and 2000 nm, preferably between 400 and 1600 nm, further preferably between 600 and 1200 nm, even further preferably between 700 and 1000 nm, e.g. between 750 and 950 nm.

2. The method of claim 1, wherein the organic semiconductor photoactive material is a bulk heterojunction.

3. The method of claim 1 or 2, wherein the additive is mixed with the host solvent in a concentration of 0.1 vol.% or more and 30 vol.% or less, preferably 1 vol.% or more and 10 vol.% or less, further preferably 1 vol.% or more and 4 vol.% or less, with respect to the mixture of host solvent and additive.

4. The method of any one of claims 1 to 3, wherein the additive is at least one of the group of 4-bromoanisole, 1,8-octanedithiol, 1,8-diiodooctane, 2-chloronaphthalene, 1,8-dibromooctane, nitrobenzene, 1,2,3,4-tetrahydronaphthalene, 1-methylnaphthalene, 2-methylnaphthalene, acetophenone, and mixtures thereof.

5. The method of any one of claims 1 to 4, wherein the host solvent is at least one of the group of chlorobenzene, chloroform, toluene, o-xylene, m-xylene, p-xylene, 1,2-dichlorobenzene, 2-methylanisole, 3-methylanisole, 4-methylanisole, and mixtures thereof.

6. The method of any one of claims 1 to 5, wherein the organic semiconductor photoactive layer is further annealed after spray-coating thereof.

7. Optoelectronic device comprising at least a bottom and a top electrode and an organic semiconductor photoactive layer between the bottom and top electrode, wherein the organic semiconductor photoactive layer is produced by the method of any one of claims 1 to 6, wherein the organic semiconductor photoactive layer has a thickness between 400 and 2000 nm, preferably between 400 and 1600 nm, further preferably between 600 and 1200 nm, even further preferably between 700 and 1000 nm, e.g. between 750 and 950 nm.

8. The optoelectronic device of claim 7, wherein a ratio of root mean square of the roughness to the, e.g. mean, thickness of the organic semiconductor photoactive layer is smaller than 0.15, preferably smaller than 0.1.

9. The optoelectronic device of claim 7 or 8, wherein the root mean square of the roughness of the organic semiconductor photoactive layer is less than 100 nm, preferably less than 50 nm.

10. The optoelectronic device of any one of claims 7 to 9, wherein the organic semiconductor photoactive layer has less than 100 defective pixels in 1 million pixels, preferably less than 50 defective pixels in 1 million pixels, further preferably less than 20 defective pixels in 1 million pixels.

11. The optoelectronic device of any one of claims 7 to 10, wherein the optoelectronic device is an organic photodetector, preferably an image sensor, e.g. a pixelated image sensor.

12. The optoelectronic device of any one of claims 7 to 10, wherein the optoelectronic device is an organic photodiode, preferably with a rectification ratio in the dark at +2V/-2V of at least $> 1 \times 10^5$, preferably $> 1 \times 10^6$, even further preferably $> 1 \times 10^7$.

13. The optoelectronic device any one of claims 7 to 10, wherein the optoelectronic device further comprises a scintillator layer and is an X-ray image sensor, e.g. a pixelated X-ray image sensor.

14. The optoelectronic device of claim 13, wherein the X-ray image sensor is a flat panel X-Ray detector.

FIG 1

FIG 2

FIG 3

FIG 4

EP 3 454 373 A1

FIG 5

FIG 6

FIG 7

FIG 8

EP 3 454 373 A1

FIG 9

FIG 10

FIG 11

FIG 12

EP 3 454 373 A1

FIG 14

FIG 13

FIG 15

FIG 16

FIG 17

FIG 18

FIG 19

FIG 20

FIG 21

FIG 22

## FIG 23

## FIG 24

FIG 25

FIG 26

## FIG 27

FIG 28

FIG 29

FIG 30

Europäisches
Patentamt

European
Patent Office

Office européen
des brevets

# EUROPEAN SEARCH REPORT

Application Number

EP 17 19 0406

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KUMAR PALANISAMY ET AL: "High-performance organic solar cells based on a low-bandgap poly-thienothiophene-benzodithiophene polymer and fullerene composite prepared by using the airbrush spray-coating technique", JOURNAL OF THE KOREAN PHYSICAL SOCIETY, KOREAN PHYSICAL SOCIETY, KR, vol. 62, no. 8, 8 May 2013 (2013-05-08), pages 1169-1175, XP035351851, ISSN: 0374-4884, DOI: 10.3938/JKPS.62.1169 [retrieved on 2013-05-08] | 1-7,10 | INV. H01L27/30 H01L51/48 ADD. G01T1/24 |
| A | * page 1169 - page 1174 * | 8,9, 11-15 | |
| X | GELINCK GERWIN H ET AL: "X-ray imager using solution processed organic transistor arrays and bulk heterojunction photodiodes on thin, flexible plastic substrate", ORGANIC ELECTRONICS, vol. 14, no. 10, 17 July 2013 (2013-07-17), pages 2602-2609, XP028707606, ISSN: 1566-1199, DOI: 10.1016/J.ORGEL.2013.06.020 | 7,8, 11-15 | TECHNICAL FIELDS SEARCHED (IPC) H01L |
| A | * page 2602 - page 2608 * | 9,10 | |
| A | YIWEI ZHANG ET AL: "Understanding and controlling morphology evolution via DIO plasticization in PffBT4T-20D/PC71BM devices", SCIENTIFIC REPORTS, vol. 7, 13 March 2017 (2017-03-13), page 44269, XP55458326, DOI: 10.1038/srep44269 * page 1 - page 10 * | 1-15 | |

-/--

The present search report has been drawn up for all claims

| Place of search | Date of completion of the search | Examiner |
|---|---|---|
| The Hague | 12 March 2018 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

**EUROPEAN SEARCH REPORT**

Application Number

EP 17 19 0406

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | COLELLA SILVIA ET AL: "Spray coating fabrication of organic solar cells bypassing the limit of orthogonal solvents", APPLIED PHYSICS LETTERS, A I P PUBLISHING LLC, US, vol. 102, no. 20, 20 May 2013 (2013-05-20), pages 203307-203307, XP012173126, ISSN: 0003-6951, DOI: 10.1063/1.4807464 [retrieved on 2013-05-24] * page 1 - page 3 * | 1-15 | |
| A | WO 2016/039887 A1 (GEN ELECTRIC [US]) 17 March 2016 (2016-03-17) * paragraph [0029] - paragraph [0075] * | 1-15 | |

TECHNICAL FIELDS
SEARCHED (IPC)

The present search report has been drawn up for all claims

| Place of search | Date of completion of the search | Examiner |
|---|---|---|
| The Hague | 12 March 2018 | Königstein, C |

EPO FORM 1503 03.82 (P04C01)

**ANNEX TO THE EUROPEAN SEARCH REPORT
ON EUROPEAN PATENT APPLICATION NO.**

EP 17 19 0406

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2018

| Patent document cited in search report | Publication date | Patent family member(s) | Publication date |
|---|---|---|---|
| WO 2016039887 A1 | 17-03-2016 | CN 106605157 A | 26-04-2017 |
| | | EP 3195361 A1 | 26-07-2017 |
| | | JP 2017532546 A | 02-11-2017 |
| | | KR 20170051463 A | 11-05-2017 |
| | | US 2016077221 A1 | 17-03-2016 |
| | | WO 2016039887 A1 | 17-03-2016 |

EPO FORM P0459

For more details about this annex : see Official Journal of the European Patent Office, No. 12/82

# EP 3 454 373 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2017011239 A1
- US 20160087219 A1
- WO 2015171640 A1
- US 20170062725 A1
- US 20140021454 A1

### Non-patent literature cited in the description

- **CHOCHOS, C. L. et al.** Rational Design of High-Performance Wide-Bandgap ($\approx$ 2 eV) Polymer Semiconductors as Electron Donors in Organic Photovoltaics Exhibiting High Open Circuit Voltages ($\approx$ 1 V). *Macromolecular Rapid Communications,* 2016
- **AÏCH, B. R et al.** Control of the active layer nanomorphology by using co-additives towards high-performance bulk heterojunction solar cells. *Organic Electronics,* 2012, vol. 13 (9), 1736-1741
- **PIVRIKAS, A. et al.** Influence of processing additives to nano-morphology and efficiency of bulk-heterojunction solar cells: A comparative review. *Solar Energy,* 2011, vol. 85 (6), 1226-1237
- **SALIM, T et al.** Solvent additives and their effects on blend morphologies of bulk heterojunctions. *Journal of Materials Chemistry,* 2011, vol. 21 (1), 242-250
- **SANDRO F. TEDDE et al.** Fully Spray Coated Organic Photodiodes. *Nano Lett.,* 2009, vol. 9 (3), 980-983
- **DANIELA BAIERL et al.** A hybrid CMOS-imager with a solution-processable polymer as photoactive layer. *Nature Communications,* 2012